# FASCICULE DE BREVET EUROPEEN

(11) **EP 3 917 298 B1**
(45) Date de publication et mention de la délivrance du brevet: **09.08.2023**
(21) Numéro de dépôt: 21173185.6
(22) Date de dépôt: 11.05.2021
(51) Int. Cl.: H05K 7/14, H05K 7/16, H05K 5/00

(54) **ENSEMBLE ELECTROMECANIQUE**
ELEKTROMECHANISCHE EINHEIT
ELECTROMECHANICAL ASSEMBLY

(30) Priorité: 28.05.2020 FR 2005648
(43) Date de publication de la demande: 01.12.2021
(73) Titulaire: THALES, 92400 Courbevoie (FR)
(72) Inventeur: PICAUT, Estelle, 33700 MERIGNAC (FR); ARNOUS, Eric, 33700 MERIGNAC (FR)
(74) Mandataire: Atout PI Laplace

(56) Documents cités:
- US-A- 5 745 342
- US-A1- 2005 138 944
- US-A1- 2007 153 469

## Description

Le domaine de l'invention est celui du montage mécanique d'équipements électroniques dans des bâtis permettant d'assurer une mise en place et une connexion électrique sécurisées. Le domaine d'application privilégié est celui de l'aéronautique et, en particulier, celui des planches de bord d'aéronef comportant plusieurs écrans de visualisation. Cependant, l'invention peut avoir un grand nombre d'applications dans tous les domaines de l'électronique professionnelle qui nécessitent des mises en place rapides et sûres.

Le montage d'un équipement électronique, généralement un dispositif de visualisation dans une planche de bord, n'est pas un problème simple pour plusieurs raisons. La face arrière de l'équipement est inaccessible pendant le montage et une fois la mise en place effectuée. L'équipement a un poids et un volume suffisants pour que les manipulations par un opérateur ne soient pas aisées. Par ailleurs, les connecteurs électriques utilisés comportent généralement plusieurs dizaines de contacts et, par conséquent, leur montage nécessite à la fois une grande précision et une certaine force d'insertion. Enfin, la mise en place tant mécanique qu'électrique doit être parfaitement assurée, compte-tenu des contraintes de sécurité et de fiabilité inhérentes à ce type de matériel embarqué.

Une solution est divulguée dans la demande de brevet publiée avec le numéro FR3035296A1, déposée par la demanderesse. Cette solution consiste à prévoir, sur chaque face latérale du boîtier électronique, une came mécanique ayant la forme sensiblement d'un quart de cercle. Une des deux extrémités de la came, disposée près du fond du boîtier, est terminée par une pointe triangulaire dirigée vers l'intérieur du cercle. La seconde extrémité de la came est disposée le long de la face avant du boîtier. Dans l'ouverture du bâti, deux pions de centrage identiques sont disposés de part et d'autre des montants de l'ouverture et agencés de façon que chaque came puisse se déplacer en rotation sur le pion qui lui correspond pendant la phase de montage du boîtier électronique dans le bâti.

La partie basse du boîtier électronique est en appui sur le bâti de façon que le boîtier électronique soit apte à tourner, par rapport au bâti, autour de cette partie basse, depuis une position ouverte dans laquelle le boîtier ouvre l'ouverture jusqu'à une position fermée dans laquelle le boîtier ferme l'ouverture.

Dans la position ouverte, les pions de centrage sont situés au niveau des pointes triangulaires des cames et les cames reposent sur les pions de centrage. La rotation du boîtier est bloquée par la coopération entre les pointes triangulaires des cames et les pions. L'accès aux connecteurs électriques est possible. Dans la position fermée, les pions de centrage sont situés au niveau des secondes extrémités des cames. La came assure le guidage du boîtier en rotation depuis la première position jusqu'à la deuxième position, et inversement.

Cette solution utilise des moyens mécaniques simples de coûts réduits et permet de réaliser des opérations de connexions mécanique et électrique de manière simple et rapide.

Toutefois, cette solution est inadaptée au montage d'écrans tactiles. En effet, les écrans tactiles doivent être installés au plus près du pilote ce qui limite le volume alloué au boîtier électronique, notamment en partie basse, afin de ne pas gêner passage des jambes du pilote ou d'être compatible avec l'installation d'une tablette ou d'une manette de contrôle. Afin de limiter le volume occupé par le boîtier électronique en partie basse en position fermée, le fond de ce dernier peut être biseauté. Le demandeur a envisagé, dans le cadre de la présente invention, de monter des cames d'un quart de cercle sur un boîtier dont le fond présente un biseau. Toutefois, de telles cames dépasseraient angulairement du fond en biseau et viendraient gêner le positionnement des jambes du pilote en position fermée. Pour éviter que les cames ne dépassent du boîtier, le biseau oblige à réduire l'angle d'ouverture des cames ce qui a pour effet de limiter le débattement angulaire du boîtier électronique et empêche un accès aisé aux connexions électriques en position ouverte.

Une autre solution est divulguée dans le document US 5 745 342 A.

Un but de l'invention est de limiter au moins un des inconvénients précités.

A cet effet, l'invention a pour objet un ensemble électromécanique comprenant un bâti. Le bâti comprend une ouverture délimitée par une traverse inférieure du bâti, la traverse inférieure s'étendant longitudinalement selon un axe longitudinal. L'ensemble électromécanique comprend un boîtier destiné à être monté sur le bâti de façon amovible de sorte que le boîtier soit apte à passer, par rotation autour de la traverse inférieure, d'une position angulaire de service dans laquelle le boîtier ferme l'ouverture, à une position angulaire de maintenance dans laquelle le boîtier ouvre l'ouverture et repose sur la traverse inférieure de sorte que la traverse inférieure empêche une translation du boîtier par rapport au bâti, contre la traverse inférieure, selon un axe perpendiculaire à l'axe longitudinal, sous l'effet de son poids, le boîtier comprenant un ensemble d'au moins une butée du boîtier, la butée du boîtier venant en appui sur une butée du bâti lorsque le boîtier se trouve dans la position angulaire de maintenance de façon à empêcher la rotation du boîtier sous l'effet de son poids autour de la traverse inférieure.

Avantageusement, le boîtier comprend une rainure destinée à recevoir la traverse inférieure pour monter le boîtier sur le bâti de façon amovible de sorte que le boîtier soit apte à passer, par rotation autour de la traverse inférieure, de la position angulaire de service à la position angulaire de maintenance.

Avantageusement, la rainure est configurée de façon que le boîtier soit en appui sur la traverse inférieure lorsque le boîtier est dans la position angulaire de maintenance de façon que le poids du boîtier tende à éloigner le boîtier de la position angulaire de service par rotation du boîtier autour de la traverse inférieure.

Dans un mode particulier de réalisation, la rainure est délimitée par une première cloison reposant sur la traverse inférieure dans la position angulaire de maintenance de sorte que la traverse inférieure empêche la translation du boîtier contre la traverse selon l'axe perpendiculaire à l'axe longitudinal, sous l'effet de son poids, la rainure étant délimitée par une deuxième cloison en appui sur la traverse inférieure lorsque le boîtier est dans la position angulaire de maintenance de sorte que le poids du boîtier tende à éloigner le boîtier de la position angulaire de service par rotation du boîtier autour de la traverse inférieure, la première cloison et la deuxième cloison étant raccordées par un fond reposant sur la traverse dans la position angulaire de service.

La première cloison et la deuxième cloison comprennent des faces internes sensiblement parallèles délimitant la rainure et étant raccordées par le fond.

Le bâti comprend une échancrure susceptible d'être traversée par la butée du boîtier suite à un soulèvement du boîtier, initialement dans la position angulaire de maintenance, par rapport au bâti.

Avantageusement, la butée du boîtier présente une forme de plaque.

Avantageusement, le bâti et le boîtier sont configurés de façon que le boîtier se trouve uniquement dans un demi-espace, délimité par un plan horizontal passant sensiblement par la traverse inférieure, dans la position angulaire de service et/ou dans la position de maintenance.

Dans un mode particulier de réalisation, le boîtier électronique comporte au moins un connecteur électrique.

Dans un mode particulier de réalisation, le bâti est une partie d'une planche de bord d'aéronef, le boîtier étant un dispositif de visualisation aéronautique.

L'invention sera mieux comprise et d'autres avantages apparaîtront à la lecture de la description qui va suivre donnée à titre non limitatif et grâce aux figures annexées parmi lesquelles :
[Fig.1] la figure 1 représente schématiquement, en vue de côté, un exemple de boîtier électronique selon l'invention,
[Fig.2] la figure 2 représente schématiquement, en vue de derrière, une partie du bâti sur lequel est destiné à être monté le boîtier électronique,
[Fig.3] la figure 3 représente schématiquement, en vue de derrière, l'ensemble électromécanique selon l'invention lorsque le boîtier électronique se trouve en position angulaire de service,
[Fig.4] la figure 4 représente schématiquement, en vue de derrière, l'ensemble électromécanique lorsque le boîtier électronique BO se trouve en position angulaire de maintenance,
[Fig.5] la figure 5 représente schématiquement, en coupe dans un plan perpendiculaire à l'axe longitudinal, un exemple de coopération entre une butée de montage et la traverse inférieure dans la position angulaire de service, une plaque avant du boîtier étant représentée partiellement et un bloc arrière du boîtier n'étant pas représenté, pour plus de clarté,
[Fig.6] la figure 6 représente schématiquement, en coupe dans le même plan de coupe que la figure 5, l'exemple de coopération entre la butée de montage et la traverse inférieure dans une position intermédiaire entre la position angulaire de service et la position angulaire de maintenance,
[Fig.7] la figure 7 représente schématiquement, en coupe dans le même plan de coupe que la figure 5, l'exemple de coopération entre la butée de montage et la traverse inférieure dans la position angulaire de maintenance,
[Fig.8] la figure 8 est une représentation schématique d'une projection, dans un plan perpendiculaire à l'axe longitudinal, des positions des butées du boîtier et des butées du bâti ainsi que de la rainure et de la traverse inférieure dans la position angulaire de maintenance,
[Fig.9] la figure 9 est une représentation schématique, en vue de côté, de l'ensemble électromécanique selon l'invention lorsque le boîtier est en position angulaire de service,
[Fig.10] la figure 10 est une représentation schématique, en vue de côté, de l'ensemble électromécanique selon l'invention lorsque le boîtier est en position angulaire de maintenance.

D'une figure à l'autre, les mêmes éléments sont repérés par les mêmes références.

L'invention se rapporte à un ensemble électromécanique comprenant un bâti et un boîtier électronique destiné à être monté de façon amovible sur le bâti.

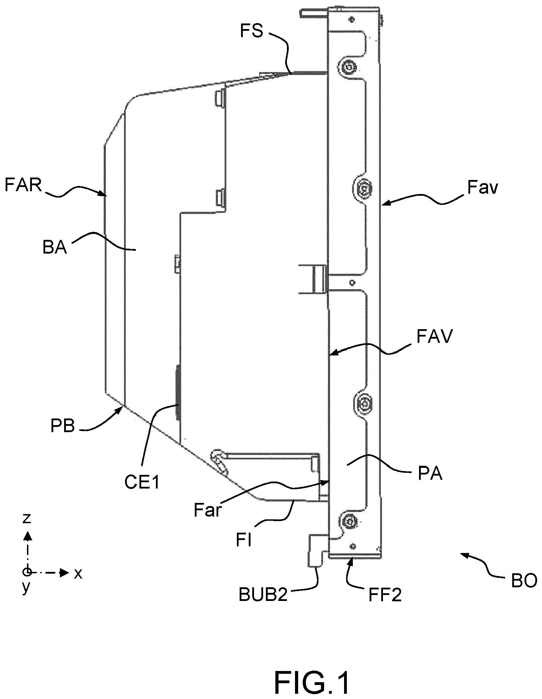

La figure 1 représente schématiquement, en vue de côté, un exemple de boîtier électronique BO d'un ensemble électromécanique selon l'invention. Un repère orthogonal (x, y, z) lié au boîtier BO est représenté sur la figure 1.

Le boîtier électronique BO comprend une plaque avant PA globalement parallélépipédique accolée à un bloc arrière BA.

Plus précisément, une face arrière Far de la plaque avant PA est accolée à une face avant FAV du bloc arrière BA. La plaque PA comprend également une face avant Fav opposée à la face avant FAV du bloc arrière BA. La face avant Fav et la face arrière Far sont les deux plus grandes faces de la plaque PA.

La plaque avant PA entoure la face avant FAV du bloc arrière BA.

Ce boîtier électronique BO est, par exemple, un dispositif de visualisation dans lequel la plaque avant PA comprend un écran, par exemple un écran tactile, et dans lequel le bloc arrière BA regroupe des fonctions électroniques.

Typiquement, l'écran présente une taille de 15", 18", 20" Un pouce, noté "), mesure 2,54 cm.

La face arrière FAR du bloc arrière BA est sensiblement parallèle à la face avant FAV du bloc arrière BA.

Le bloc arrière BA comprend une face supérieure FS et un fond FI, reliant chacun, la face avant FAV du bloc arrière BA à une face arrière FAR du bloc arrière BA.

Le fond FI du bloc arrière BA comprend une face en biseau PB qui est sensiblement plane et inclinée par rapport à la face arrière FAR du bloc arrière BA. Autrement dit, la face en biseau PB forme un angle non nul et inférieur à 90° avec la face avant FAV autour de l'axe y de la plaque avant PA, perpendiculaire au plan de la figure 1, qui sera définit ultérieurement. De la sorte, la face arrière FAR du bloc arrière BA est plus éloignée d'un fond FF2 de la plaque avant PA que la face avant FAV du bloc arrière BA selon l'axe z de la plaque avant PA, qui sera décrit ultérieurement.

Le boîtier électronique BO comprend une première connectique électrique CE1 destinée à être reliée électriquement à une deuxième connectique électrique du bâti BAT, par exemple, par un toron de câble.

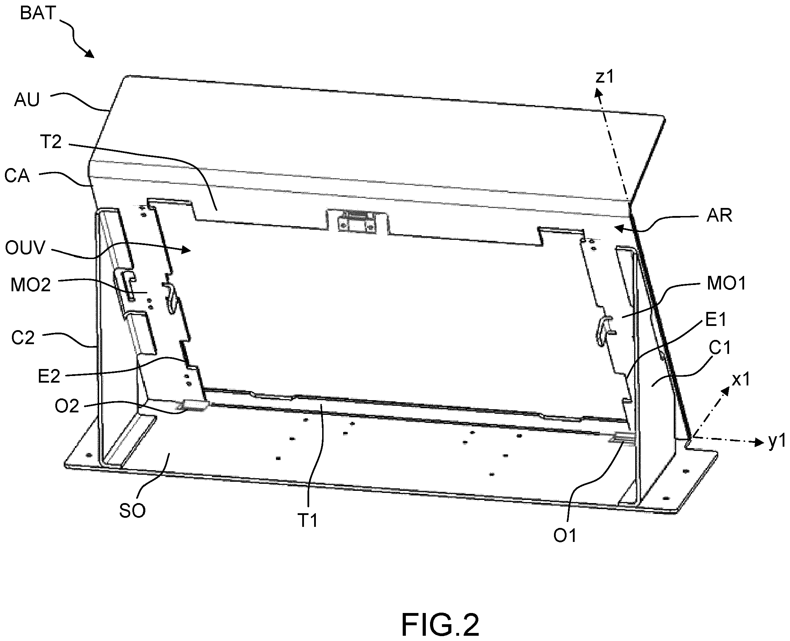

La figure 2 représente schématiquement le bâti BAT en vue de derrière ainsi qu'un repère orthogonal (x1, y1, z1) lié au bâti BAT.

Le bâti BAT est, par exemple, une partie d'une planche de bord d'aéronef.

Le bâti BAT comprend un cadre CA sensiblement plan, définissant un plan (y1, z1).

Le cadre CA délimite une ouverture OUV.

Le cadre CA comprend une traverse inférieure T1, une traverse supérieure T2 et deux montants dont un premier montant MO1, un deuxième montant MO2. Chaque montant MO1, MO2 raccorde les deux traverses T1 et T2 entre elles.

La traverse inférieure T1 s'étend longitudinalement selon un axe longitudinal y1 de la traverse inférieure T1.

Avantageusement, la traverse supérieure T2 s'étend longitudinalement parallèlement à l'axe y1.

Avantageusement, les montants MO1, MO2 s'étendent longitudinalement selon des axes respectifs parallèles à l'axe z1.

Le plan du cadre CA est incliné par rapport à un plan horizontal et l'axe y1 est destiné à être horizontal en service et en maintenance.

De préférence, l'angle formé entre le plan du cadre CA et le plan horizontal est supérieur ou égal à 20° et inférieur ou égal à 90°.

Par plan horizontal, on entend un plan perpendiculaire à la gravité.

Le cadre CA est, par exemple, mais non nécessairement, raccordé à une plaque inférieure SO sensiblement plane destinée à être sensiblement horizontale en en service et en maintenance.

La plaque inférieure est, par exemple, un carter ou une tablette.

Elle peut faire partie du bâti ou non et être fixe ou mobile par rapport au cadre CA.

La plaque inférieure SO est sensiblement plane et définit un plan de la plaque horizontal lors du montage/démontage et en service.

Lorsque le bâti BAT est une partie d'une planche de bord d'un aéronef, le bâti BAT est, avantageusement, monté sur l'aéronef de façon que l'axe y1 et le plan de défini par la plaque inférieure SO soient sensiblement horizontaux lorsque l'aéronef présente une gîte et une assiette nulles.

Le plan défini par la plaque inférieure SO délimite, par exemple, un demi-espace dans lequel les jambes du pilote sont situées en opération. Les jambes du pilote sont situées en-dessous de ce demi plan.

Afin de ne pas gêner le positionnement des jambes du pilote ou l'installation d'équipements tels qu'une manette de contrôle, le boîtier BO doit se situer essentiellement au-dessus du plan défini par la plaque inférieure SO lorsqu'elle est horizontale. Le dessus et le dessous sont définis selon un axe vertical défini par la gravité lors du montage et du démontage du boîtier BO et en service.

La traverse inférieure T1 s'étend au-dessus de la plaque inférieure SO, sensiblement jusqu'au plan défini par la plaque inférieure SO.

En variante, l'ensemble électromécanique est dépourvu de plaque inférieure.

Le cadre CA comprend une face avant non visible en figure 2 et une face arrière AR. L'avant et l'arrière et le devant, le derrière sont définis selon l'axe x1.

Le cadre CA est raccordé à la plaque inférieure SO par des contreforts C1 et C2 dans l'exemple non limitatif de la figure 2.

Le bâti BAT comprend un auvent AU ou casquette du bâti BAT. L'auvent AU est, par exemple, une partie d'une planche de bord d'un aéronef destinée à protéger le pilote de l'éclairage direct et des reflets du soleil qui gênent pour la lisibilité sur l'écran.

L'auvent AU s'étend au-dessus de la traverse supérieure T2, c'est-à-dire, de l'autre côté de l'ouverture OUV par rapport à la traverse supérieure T2 selon l'axe z1.

L'auvent AU s'étend devant le cadre CA. Il est donc susceptible de gêner l'accès à la connectique.

En variante, le bâti BAT est dépourvu d'auvent AU.

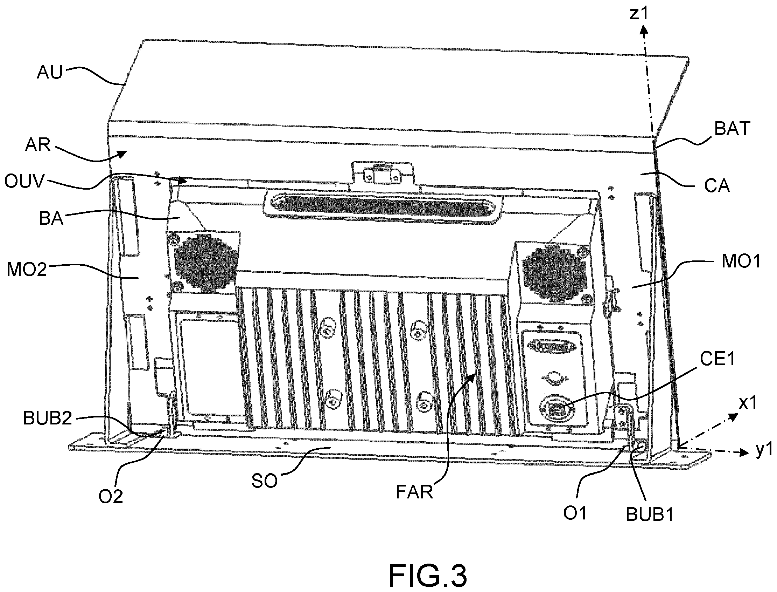

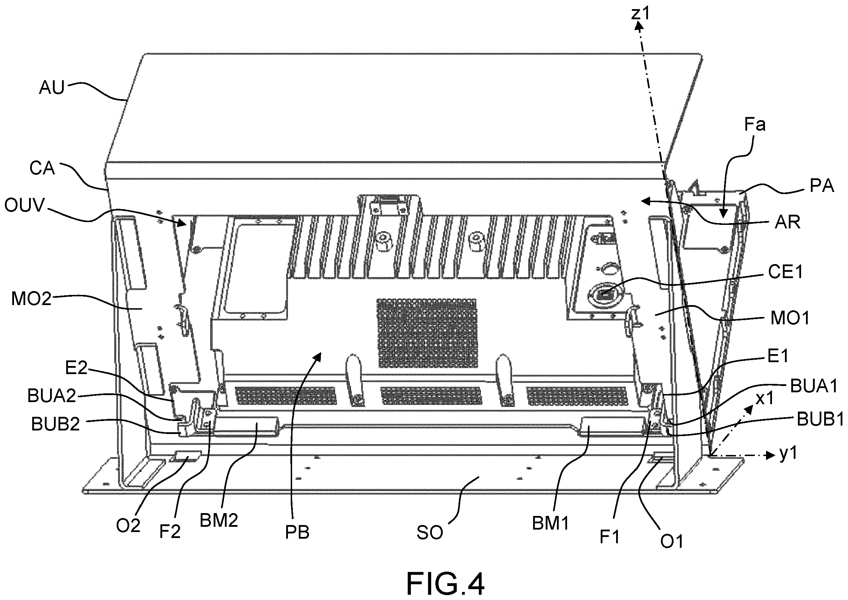

Les figures 3 et 4 représentent schématiquement, en vue de derrière, l'ensemble électromécanique lorsque le boîtier électronique BO se trouve dans une position angulaire de service (figure 3) et, respectivement, dans une position angulaire de maintenance (figure 4), par rapport au bâti BAT.

Le boîtier électronique BO et le bâti BAT sont configurés de façon que, lorsque le boîtier électronique BO est monté de façon amovible sur le bâti BAT, le boîtier BO est lié au bâti BAT en rotation autour de la traverse inférieure T1 de sorte que le boîtier BO est apte à passer, par rotation du boîtier BO autour de la traverse T1, de la position angulaire de service, telle que visible en figure 3, dans laquelle le boîtier BO ferme l'ouverture OUV, à la position angulaire de maintenance telle que représentée en figure 4, dans laquelle le boîtier BO ouvre l'ouverture OUV.

Le boîtier est apte à passer de la position angulaire de maintenance à la position angulaire de service par une rotation en sens inverse.

Lorsque le boîtier BO est monté sur le bâti BA, l'axe y du boîtier BO est parallèle à l'axe y1 du bâti BAT.

Le boîtier BO est lié en rotation au bâti BAT autour d'un axe de rotation qui passe par la traverse T1 et qui est parallèle à l'axe longitudinal y1 de la traverse T1.

Le boîtier BO passe de la position angulaire de service à la position angulaire de maintenance, et inversement, uniquement par rotation autour de la traverse T1, et plus précisément autour de l'axe de rotation.

La position angulaire de service et la position angulaire de maintenance sont des positions angulaires de repos du boîtier BO par rapport au bâti BAT. Autrement dit, le boîtier BO est fixe par rapport au bâti BAT en rotation autour de la traverse T1, et plus particulièrement autour de l'axe de rotation, dans chacune de ces deux positions.

Le boîtier BO est configuré de façon à reposer sur la traverse inférieure T1 dans la position angulaire de maintenance de la figure 4. De la sorte, la traverse inférieure T1 exerce, sur le boîtier BO, une réaction empêchant une translation, ou un glissement, du boîtier BO par rapport au bâti BAT le long de l'axe z1 sous l'effet du poids du boîtier BO.

Dans la position angulaire de maintenance, la traverse inférieure T1 exerce donc, sur le boîtier BO, une réaction présentant une première composante selon l'axe z1 dirigée vers la traverse supérieure T2.

Cette première composante présente donc une composante verticale dirigée vers le haut. Par composante verticale, on entend une composante parallèle au poids du boîtier BO. La composante verticale est dirigée vers le haut lorsqu'elle est dirigée en sens inverse du poids du boîtier BO.

Le dispositif de montage du boîtier BO sur le bâti BAT sera décrit plus précisément dans la suite de la description.

Selon l'invention, comme visible en figure 4, le boîtier BO comprend un ensemble de butées du boîtier BUB1, BUB2, venant chacune en appui sur une butée du bâti BUA1, BUA2 lorsque le boîtier BO se trouve dans la position angulaire de maintenance par rapport au bâti BAT de façon à maintenir le boîtier BO dans la position angulaire de maintenance.

Autrement dit, la coopération des butées du boîtier BUB1, BUB2 avec celles du bâti BUA1, BUA2, permet de limiter la rotation du boîtier BO autour de la traverse inférieure T1 sous l'effet de son poids, dans le sens de la position angulaire de service vers la position angulaire de maintenance, de façon à maintenir le boîtier BO dans la position angulaire de maintenance par rapport au bâti BAT. La position angulaire de maintenance est alors une position angulaire de repos du boîtier BO.

Cette configuration présente l'avantage de séparer la zone du boîtier BO qui repose sur le bâti BAT pour éviter son glissement vers le bas contre le cadre CA de la zone du boîtier BO qui vient en appui sur le bâti BAT pour limiter la rotation du boîtier BO autour de la traverse inférieure T1 de façon que la position angulaire de maintenance soit une position de repos.

Cette solution permet de définir différentes configurations des butées du boîtier BUB1 et BUB2 et du bâti BAT ce qui permet de définir différents débattements angulaires entre la configuration de service et la configuration de maintenance. Cette solution permet d'obtenir un débattement angulaire important pouvant largement dépasser 60° sans venir gêner les jambes du pilote ou l'installation d'une manette.

Cette configuration laisse le choix dans le positionnement des butées BUB1 et BUB2 coopérant avec les butées du bâti BUA1 et BUA2. Il est notamment possible de disposer ces butées BUB1 et BUB2 très proches de l'axe de rotation du boîtier BO autour de la traverse inférieure T1 dans des zones ne venant pas gêner le positionnement des jambes du pilote lorsque le boîtier BO se trouve dans la position angulaire de service. Il suffit que l'appui entre les butées BUB1 et BUB2 soit distant de l'axe de rotation dans la position angulaire de maintenance pour que la coopération des butées puisse empêcher la rotation du boîtier d'aller au-delà de la position angulaire de maintenance.

Cette solution présente également l'avantage d'être compatible avec un fond de bloc arrière BA biseauté.

Dans la réalisation particulière des figures, chaque butée du boîtier BUB1, BUB2 vient en appui sur la face arrière AR du cadre CA et, plus particulièrement, sur une face arrière d'un des montants MO1, MO2 du cadre CA.

Autrement dit, les deux butées du bâti BUA1 et BUA2 sont séparées par l'ouverture OUV le long de l'axe y1.

Dans la réalisation non limitative des figures, la portion de la face arrière AR sur laquelle chaque butée du boîtier BUB1, BUB2 vient en appui est sensiblement plane.

Dans la réalisation avantageuse des figures, les butées du boîtier BUB1 et BUB2 sont réalisées sous forme de plaques sensiblement planes comprenant chacune une face plane venant en appui sur la partie plane de la face arrière d'un des montants MO1, MO2, comme visible en figure 4. Les butées du boîtier BUB1, BUB2 sont, par exemple, reliées à la plaque PA par des dispositifs de fixation respectif F1, F2. Cette solution est simple à réaliser et bon marché. Elle est, par ailleurs, peu volumineuse.

Avantageusement, chaque butée du boîtier BUB1, BUB2 vient en appui sur le bâti BAT à proximité de l'extrémité longitudinale d'un des montants MO1, MO2, ladite extrémité étant raccordée à la traverse inférieure T1.

Les butées du boîtier BUB1 et BUB2 peuvent, en variante, présenter une forme d'élément sensiblement cylindrique allongé selon l'axe y du boîtier BO.

L'ensemble de butée du boîtier peut, en variante, comprendre une unique butée du boîtier ou plus de deux butées du boîtier BO.

En variante, l'ensemble de butées du boîtier BUB1, BUB2 et l'ensemble de butées du bâti sont en outre configurés de façon à maintenir le boîtier BO fixe par rapport au bâti en translation selon l'axe y1 dans la position angulaire de maintenance.

A cet effet, des rainures sont, par exemple, ménagées dans les butées du boîtier. Ces rainures sont configurées pour recevoir des protubérances des butées du bâti dans la position angulaire de maintenance.

Comme visible en figure 4, le bâti BAT comprend des échancrures E1, E2. Chaque échancrure E1, E2 est susceptible d'être traversée par une des butées du boîtier BUB1, BUB2 suite à un soulèvement du boîtier BO, initialement dans la position angulaire de maintenance.

Dans la réalisation des figures, les échancrures E1, E2 sont susceptibles d'être traversées par une des butées BUB1 ou BUB2 du boîtier BO, suite à un soulèvement du boîtier BO, initialement dans la position angulaire de maintenance, par glissement du boîtier BO par rapport au cadre CA, le long de l'axe z1 du cadre CA. Le montage du boîtier BO sur le bâti BAT se fait par le mouvement inverse. On comprend donc que, une fois dans la position angulaire de maintenance, le boîtier BO est aisément séparable du bâti BAT en soulevant simplement le boîtier BO puis en le tirant vers l'avant.

Dans la réalisation des figures, les échancrures sont ménagées dans les montants MO1 et MO2 au-dessus des butées respectives BUA1 et BUA2 du bâti BA.

En variante, une seule échancrure est prévue.

Nous allons maintenant décrire plus précisément le montage du boîtier BO en rotation sur le bâti BAT.

Comme visible en figure 4, le boîtier BO comprend des butées de montage BM1, BM2 espacées selon l'axe y du boîtier BO. En variante, le boîtier comprend une seule ou plus de deux butées de montage.

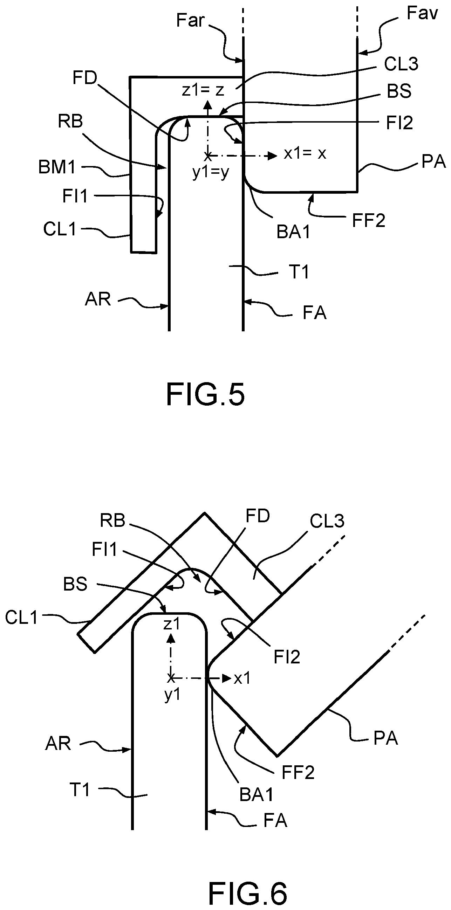

Chaque butée de montage BM1, BM2 forme, dans l'espace situé entre la butée de montage BM1, BM2 et la face arrière Far de la plaque avant PA, une rainure du boîtier RB, visible sur les figures 5 à 8. Seule la rainure RB délimitée par la première butée de montage BM1 est représentée sur les figures 5 à 7 et décrite ci-dessous mais la deuxième butée de montage BM2 est configurée et montée sur la traverse inférieure T1 de la même façon que la première butée de montage BM1.

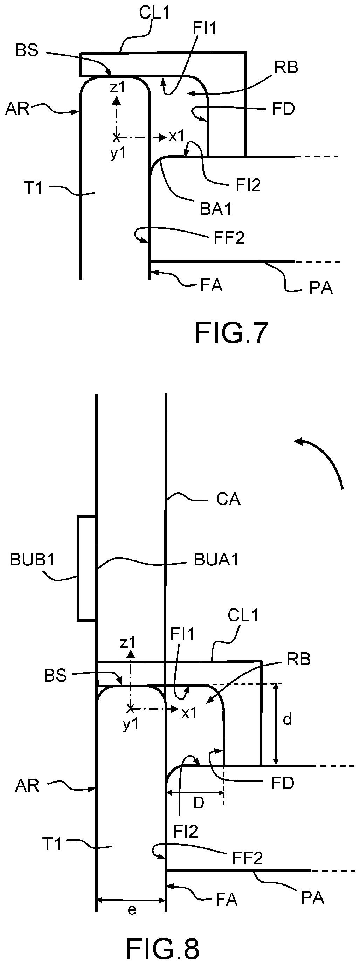

La rainure RB est destinée à recevoir la traverse inférieure T1 de façon à monter le boîtier BO de façon amovible sur le bâti BAT, en rotation autour de la traverse inférieure T1, de sorte que le boîtier BO soit apte à passer de la position angulaire de service, représentée en figure 5, à la position angulaire de maintenance, telle que représentée en figure 7, par rotation du boîtier BO autour de la traverse inférieure T1 et plus particulièrement autour d'un axe de rotation parallèle à l'axe y1. Lors de la rotation, le boîtier BO passe par une position intermédiaire telle que représentée en figure 6. Sur les figures 5 à 7 et sur la figure 8, le cadre CA est situé dans un plan vertical mais en pratique, comme expliqué précédemment, le plan (y1 ; z1) du cadre CA est préférablement inclinée par rapport à la verticale comme visible en figures 3 et 4.

La rainure RB est délimitée, selon l'axe x du boîtier, qui est parallèle à l'axe x1 dans la position angulaire de service, par une face interne FI1 d'une première cloison CL1 et par une face interne FI2 d'une deuxième cloison qui est la plaque avant PA dans l'exemple non limitatif de la figure 2. La rainure RB est délimitée, selon l'axe z qui est parallèle à l'axe z1 dans la position angulaire de service, par un fond FD reliant les deux faces internes FI1 et FI2.

Les faces FI1 et FI2 et le fond FD sont allongés selon l'axe y.

Dans l'exemple non limitatif des figures, la butée de montage BM1 est coudée et comprend la première cloison CL1 et une troisième cloison CL3 dont la face interne, tournée vers la traverse inférieure T1, est le fond FD.

La traverse inférieure T1 présente sensiblement une forme d'une plaque rectangulaire allongée selon l'axe y1, délimitée par une face avant et une face arrière faisant partie respectivement de la face avant FA du cadre CA et de la face arrière AR du cadre CA. La face avant FA et la face arrière AR sont sensiblement parallèles au plan (y1, z1).

Dans la position angulaire de service, comme visible en figure 5, le fond FD repose sur la traverse T1 et, plus particulièrement, sur un bord supérieur BS de la traverse T1 reliant la face avant FA à la face arrière AR du cadre CA et délimitant l'ouverture OUV. De la sorte, la traverse T1 exerce, sur le boîtier BO, une réaction empêchant une translation, ou un glissement, du boîtier BO par rapport au bâti BAT le long de l'axe z1 sous l'effet du poids du boîtier BO.

Dans la position intermédiaire de la figure 6, l'axe de rotation du boîtier BO autour de la traverse T1 se trouve au niveau du bord arrondi BA1 de plaque PA situé à l'extrémité, de la deuxième face interne FI2, opposée au fond FD.

L'axe de rotation se déplace le long de ce bord arrondi BA1 jusqu'à atteindre la face d'extrémité FF2 de la plaque PA, dans la position angulaire de maintenance.

La plaque PA ou, de façon plus générale, la deuxième cloison, est dimensionnée de façon à être en appui sur la face avant FA de la traverse T1 dans la position angulaire de maintenance de sorte que la traverse T1 exerce, sur la deuxième cloison PA, une réaction présentant un composante perpendiculaire à la face avant FA du cadre CA, et plus particulièrement à la face avant FA de la traverse inférieure T1, vers l'avant.

La position de l'appui de la deuxième cloison PA sur la face avant de la traverse T1 constitue l'axe de rotation du boîtier BO autour de la traverse inférieure T1.

Dans l'exemple de la figure 7, c'est la face d'extrémité FF2 de la deuxième cloison PA qui vient en appui sur la face avant FA de la traverse T1.

La première cloison CL1 est dimensionnée de façon que la première cloison CL1 du boîtier BO repose sur la traverse inférieure T1 dans la position angulaire de maintenance.

La traverse T1 exerce alors, dans la position angulaire de maintenance, une réaction empêchant une translation, ou un glissement, du boîtier BO par rapport au bâti BAT le long de l'axe z1 de la traverse inférieure T1 sous l'effet du poids du boîtier BO.

Plus précisément, la première cloison CL1 repose sur le bord supérieur BS de la traverse inférieure T1.

Malgré ces appuis, la rotation du boîtier BO autour de la traverse inférieure T1 a tendance à se poursuivre au-delà de la position angulaire de maintenance, sous l'effet du poids du boîtier BO dont le centre de gravité est situé devant l'axe de rotation selon l'axe x1. Cette rotation a tendance à éloigner le boîtier BO de la position angulaire de service.

La figure 8 est une représentation schématique d'une projection, dans un plan perpendiculaire à l'axe y1, des positions des butées du boîtier BO et du bâti BAT ainsi que de la rainure RB et de la traverse inférieure T1 dans la position angulaire de maintenance.

Comme représenté en figure 8, la rotation du boîtier BO autour de l'axe de rotation par rapport au bâti BAT est limitée par la coopération entre les butées du boîtier BUB1 et BUB2 et les butées du bâti BUA1, BUA2.

Dans la réalisation particulière des figures, chacune des butées du boîtier BUB1 et BUB2 vient en appui sur une butée du bâti BUA1, BUA2 appartenant à un des montants du boîtier MO1, MO2 de façon à empêcher la rotation du boîtier BO de se poursuivre au-delà de la position angulaire de maintenance. Chaque montant MO1, MO2 exerce sur une des butées du boîtier BUB1, BUB2, une réaction comprenant une composante radiale dans le sens de rotation représenté par une flèche sur la figure 8, allant dans le sens de la position angulaire de maintenance vers la position angulaire de service.

Dans la réalisation des figures, les butées de montage BM1, BM2, les butées du boîtier BUB1, BUB2 et les butées du bâti BUA1, BUA2 sont configurées et positionnées, de façon que le boîtier BO effectue, depuis la position angulaire de service jusqu'à la position angulaire de maintenance, une rotation autour de la traverse T1 d'un angle sensiblement égal à 90°.

De façon plus générale, les butées de montage BM1, BM2, les butées du boîtier BUB1, BUB2 et les butées du bâti BUA1, BUA2 sont configurées et positionnées, compte tenu des formes et dimensions du bloc arrière BA, de la plaque avant PA et de la traverse T1 de façon que le boîtier BO effectue, depuis la position angulaire de service jusqu'à la position angulaire de maintenance une rotation autour de la traverse T1, d'un angle de préférence supérieur ou égal à 60° et inférieur à 180°, afin de faciliter l'accès aux connecteurs, dans la position de maintenance, tout en limitant le volume occupé sous le plan limite dans la position de maintenance.

Pour modifier l'angle de rotation du boîtier BO entre la position angulaire de service et la position angulaire de maintenance, il est possible de modifier l'inclinaison du plan des butées du boîtier BM1 et BM2 par rapport au plan du cadre CA et/ou de raccorder la face avant de la plaque avant à la face arrière de la plaque avant par une face d'extrémité FF2 en biseau par rapport à ces plaques et dont l'inclinaison est déterminée de façon que cette face en biseau vienne en appui sur la face avant de la traverse inférieure dans la position angulaire de maintenance prédéterminée.

Dans l'exemple non limitatif des figures, la rainure RB présente une forme globalement rectangulaire dans le plan perpendiculaire à l'axe y.

La rainure RB et la traverse inférieure T1 présentent chacune une forme sensiblement rectangulaire dans le plan (y1, z1) perpendiculaire au plan des figures 5 à 7, l'axe de rotation n'est pas fixe. Il se déplace par rapport à la traverse T1 et par rapport au boîtier BO lors de la rotation du boîtier BO au voisinage de la rainure RB et du bord supérieur BS de la traverse inférieure T1.

Les première et deuxième faces internes FI1 et FI2 sont sensiblement parallèles entre elles et perpendiculaires au fond FD.

Par ailleurs, la face d'extrémité FF2 de la deuxième cloison PA est sensiblement perpendiculaire à la face interne FI2.

La largeur d de la rainure RB, c'est-à-dire la distance entre la première cloison CL1 et la deuxième cloison PA selon l'axe x, est supérieure à l'épaisseur e de la traverse inférieure T1 (distance entre sa face avant FA et la face arrière AR du cadre CA) de façon à permettre la position angulaire de service.

La profondeur D de la rainure RB, correspondant à la dimension de la deuxième cloison PA selon l'axe z depuis le fond FD jusqu'à la face d'extrémité FF2, est inférieure à la largeur d de façon à permettre la rotation du boîtier BO autour de la traverse T1.

Pour fluidifier la rotation du boîtier BO autour de la traverse T1, le bord supérieur BS de la traverse inférieure T1 est raccordé aux faces avant FA et arrière AR de la traverse inférieure T1 par des bords arrondis, la face interne FI1 de la première cloison CL1 est raccordé au fond FD de la rainure RB par un bord arrondi et la face interne FL2 de la deuxième cloison CL2 est raccordée à la face d'extrémité FF2 de la deuxième cloison PA par un bord arrondi BA1. Le rayon de chaque arrondi est adapté en fonction de l'épaisseur de la traverse T1. Chaque bord arrondi présente une forme de courbe convexe dans le plan perpendiculaire à l'axe y.

Afin de fluidifier la rotation du boîtier BO, le bâti BAT et/ou chaque butée de montage BM1, BM2 sont avantageusement réalisés en un matériau présentant un faible coefficient de frottement, par exemple en nylon ou en téflon.

La réalisation de rainures et de traverses à section globalement rectangulaire dans un plan perpendiculaire à l'axe y est aisée.

La traverse inférieure T1 et la rainure RB ne présentent pas obligatoirement une section globalement rectangulaire. En variante, le bord supérieur BS de la traverse inférieure T1 est, par exemple, circulaire dans un plan perpendiculaire à l'axe y1 et chaque rainure RB présente une forme circulaire dans le plan perpendiculaire à l'axe y. L'axe de rotation du boîtier BO par rapport à la traverse T1 est alors fixe.

La disposition des butées du boîtier BUB1, BUB2 dépend de la taille relative de la plaque avant PA et du bloc arrière BA. Ces butées peuvent être fixées à la plaque avant PA comme dans la réalisation de la figure, ou au bloc arrière BA. Elles peuvent en variante être ménagées dans la plaque avant PA ou dans le bloc arrière BA.

La disposition des butées de montage BM1, BM2 dépend de la taille relative de la plaque avant PA et du bloc arrière BA. Chaque butée de montage BM1, BM2 peut être fixée à la plaque avant PA, comme dans l'exemple des figures, ou au bloc arrière BA. En variante, chaque butée de montage BM1, BM2 peut faire partie du bloc arrière BA ou de la plaque avant PA. Chaque rainure RB est alors ménagée dans le bloc arrière BA ou dans la plaque PA.

La solution proposée est adaptable à n'importe quel boîtier BO en rapportant les butées à l'endroit convenant à la taille relative de la plaque avant PA et du boîtier BO. La solution proposée est en outre facilement adaptable à différentes dimensions de la traverse inférieure T1.

Dans la réalisation des figures, le boîtier BO comprend deux butées de montage BM1, BM2. En variante, le boîtier comprend une seule ou plus de deux butées de montage.

Des moyens, par exemple, des butées transversales, par exemple des rainures comme expliqué précédemment, sont avantageusement prévues pour empêcher une translation du boîtier BO par rapport au bâti BAT selon l'axe y1 lorsque le boîtier est monté sur le bâti BAT.

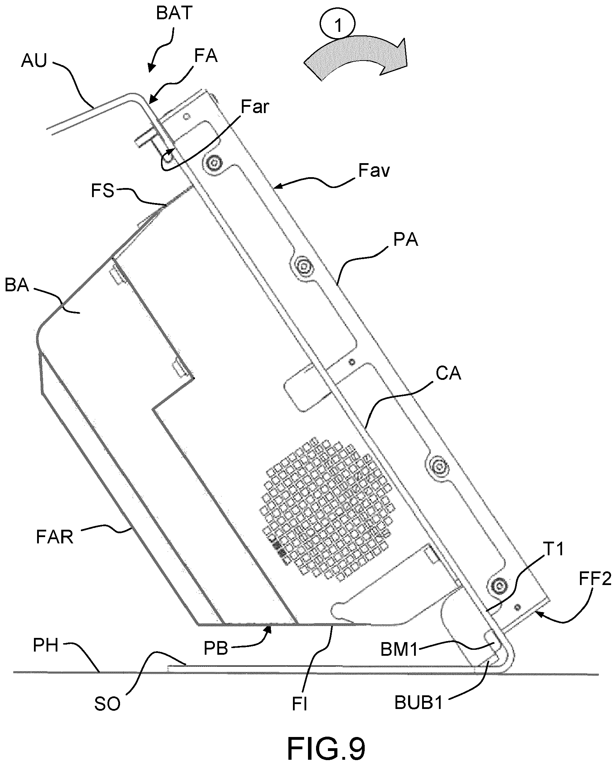

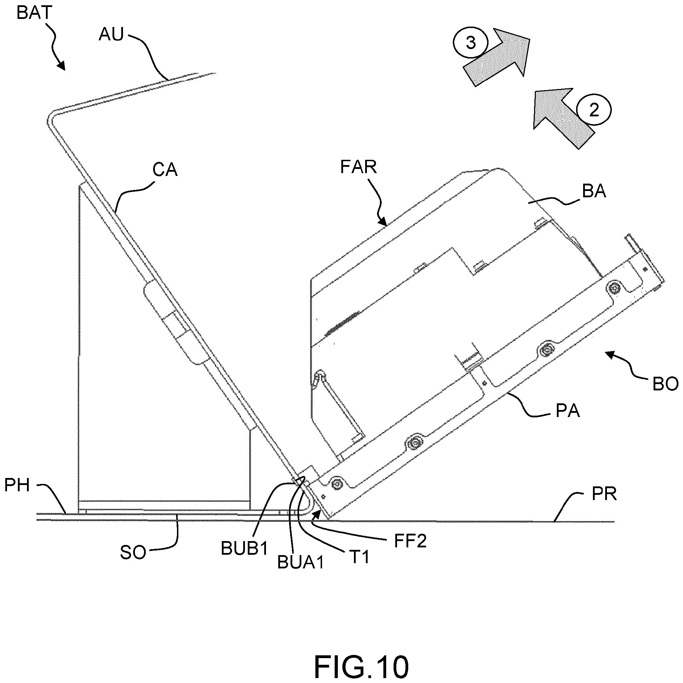

La séquence de démontage du boîtier BO dans l'ouverture OUV du bâti B1 est décrite en référence aux figures 9 et 10. Sur ces figures, les larges flèches indiquent les différents mouvements du boîtier BO.

Dans la position angulaire de service représentée en figure 9, le bloc arrière BA passe à travers l'ouverture OUV et la plaque avant PA se trouve devant le cadre CA selon l'axe x1.

La plaque avant PA du boîtier BO, et plus particulièrement la face arrière Far de la plaque avant PA est plaquée contre la face avant FA du cadre CA. L'inclinaison du cadre CA et donc de la plaque avant PA, par rapport à un plan horizontal PH permet de favoriser l'ergonomie, notamment pour lorsque la plaque est du type écran tactile.

Le boîtier BO repose sur la traverse T1. Le fond FD de la rainure RB repose sur la traverse T1 comme représenté en figure 5.

La face arrière Far et la face avant Fav de la plaque avant PA sont sensiblement parallèles au plan (y1, z1) du cadre CA.

Le fond FI du bloc arrière BA est situé en-dessous de la face supérieure FS.

Les butées du boîtier BUB1 et BUB2 s'étendent sensiblement à la hauteur de la plaque inférieure SO tout en étant totalement comprises dans le même demi-espace, délimité par le plan horizontal PH de la plaque inférieure SO, que le reste du boîtier BO. Cela permet d'éviter de gêner un positionnement des jambes du pilote.

Des ouvertures élémentaires O1 et O2, visibles en figure 4, sont, par exemple, aménagées dans la plaque inférieure SO pour recevoir les butées BUB1 et BUB2 dans la position angulaire de service comme visible en figure 9.

Le boîtier BO est maintenu dans le bâti BAT en position angulaire de service par différents moyens de fixation non représentés sur les différentes figures. Ces moyens sont, par exemple, une poignée de fixation ou des vis de fixation.

On déverrouille tout d'abord le boîtier BO du bâti BAT.

Dans un premier temps, on bascule le boîtier BO vers l'avant, comme représenté par la première large flèche 1. Le boîtier BO tourne autour de la traverse inférieure T1, de la position angulaire de service jusqu'à la position angulaire de maintenance. A la fin du mouvement, le boîtier BO vient occuper la position représentée en figure 10. Dans cette position angulaire de maintenance, les butées du boîtier BUB1 et BUB2 viennent en appui contre les butées respectives du bâti BUA1 et BUA2 comme représenté en figures 8 et 10.

Dans la position angulaire de maintenance, le bloc arrière BA est situé complètement devant le cadre CA et la plaque PA, et plus précisément sa face avant Fav est inclinée par rapport au plan (y1, z1) du cadre CA.

La première cloison CL1 repose sur la traverse T1, comme visible en figure 7, et la deuxième cloison PA, et plus particulièrement la face FF2, est en appui sur la traverse inférieure T1.

Lorsque le boîtier BO est dans cette position angulaire de maintenance, qui est une position angulaire de repos du boîtier, l'accès à la face arrière du boîtier BO et, éventuellement, à des connecteurs solidaires du système avionique est facilité. Il est notamment possible de déconnecter ou de connecter un connecteur électrique du boîtier BO d'un connecteur électrique du système avionique.

Avantageusement, comme visible en figure 10, le boîtier BO est situé totalement dans un demi-espace délimité par un plan de référence PR sensiblement horizontal et situé sensiblement à une même côte, selon un axe vertical perpendiculaire à ce plan de référence PR, que la traverse T1 ou que la plaque inférieure SO.

Dans la réalisation non limitative des figures le plan de référence PR est situé à une côte inférieure à celle du plan défini par la plaque inférieure SO et/ou à celle de la traverse inférieure T1, sensiblement à une même côte que le plan défini par la plaque inférieure SO et/ou que la traverse inférieure T1. Ces plans pourraient en variante être à la même côte.

Cela permet à la solution proposée d'être compatible avec la présence d'autres dispositifs, devant le cadre CA, comme par exemple une manette.

Avantageusement, le boîtier BO et le bâti BAT sont configurés de façon que le boîtier BO s'étende uniquement dans le demi-espace défini par le plan de référence PR, dans la position angulaire de maintenance, dans la position angulaire de service et quelle que soit la position du boîtier BO entre la position angulaire de maintenance et la position angulaire de service.

Dans la réalisation non limitative des figures, le débattement angulaire entre la position angulaire et service et la position angulaire de maintenance est de 90°.

En variante, le débattement angulaire est défini de façon que la face avant Fav de la plaque avant PA s'étende sensiblement dans un plan horizontal dans la position angulaire de maintenance. Il est, par exemple, possible de prévoir une face d'extrémité FF2 en biseau par rapport à la face avant Fav de la plaque avant PA pour permettre cette position angulaire. Cette variante est avantageuse car elle induit un débattement angulaire important favorisant l'accès à des connectiques dans la position de maintenance tout en étant compatible de l'installation d'équipements sous le plan de référence PR devant le cadre.

Dans un deuxième temps représenté par la deuxième large flèche 2 en figure 10, on fait glisser le boîtier BO vers le haut le long du cadre CA pour amener les butées du boîtier BUB1 et BUB2 face aux échancrures E1, E2 respectives du cadre CA de façon à permettre de séparer boîtier du bâti BA.

Dans un troisième temps représenté par la troisième large flèche 3, on sépare le boîtier BO du cadre CA en tirant le boîtier BO vers l'avant de façon que les butées du boîtier BUB1, BUB2 traversent les échancrures respectives E1, E2.

Afin de permettre un tel mouvement vers l'avant, chaque rainure RB est avantageusement configurée de façon que dans la configuration de maintenance, un mouvement de translation du boîtier BO selon l'axe x1 est autorisé vers l'avant.

Dans la réalisation des figures, dans la configuration de maintenance, un mouvement de translation du boîtier BO selon l'axe x1 est autorisé uniquement dans un sens.

Le montage du boîtier BO se fait aisément en suivant la séquence inverse de celle du montage.

Les avantages principaux de cet ensemble électromécanique sont les suivants :
- Utilisation de moyens mécaniques simples de coûts réduits ;
- Grande facilité de montage qui peut se faire sans outils,
- Grande rapidité de montage ;
- Grande amplitude de mouvement entre la position angulaire de service et la position angulaire de maintenance.
- Position angulaire de maintenance sécurisée,
- Compacité et, en particulier, possibilité d'occupation d'un volume ne dépassant pas, en position angulaire de service et/ou en position angulaire de maintenance, un plan horizontal situé sensiblement à une hauteur inférieure du cadre : absence de conflit avec le positionnement du pilote et/ou d'autres équipements situés devant le bâti, sous le bâti.
- Compatibilité avec les contraintes d'environnement avioniques (vibratoire, thermique, étanchéité, compatibilité électromagnétique)
- Compatibilité avec différentes tailles d'écran ou plaques avant,
- Accès manuel aisé aux connecteurs pour la connexion ou déconnexion des connecteurs en position angulaire de maintenance,
- Compatibilité avec différents types de connecteurs (taille, sortie des câbles électriques) et différentes positions des connecteurs,
- Bâti simple et peu cher.

## Revendications

1. Ensemble électromécanique comprenant un bâti (BAT) comprenant une ouverture (OUV) délimitée par une traverse inférieure (T1) du bâti (BAT), la traverse inférieure (T1) s'étendant longitudinalement selon un axe longitudinal (y1), **caractérisé en ce que** l'ensemble électromécanique comprend un boîtier (BO) destiné à être monté sur le bâti (BAT) de façon amovible de sorte que le boîtier (BO) soit apte à passer, par rotation autour de la traverse inférieure (T1), d'une position angulaire de service dans laquelle le boîtier (BO) ferme l'ouverture (OUV), à une position angulaire de maintenance dans laquelle le boîtier (BO) ouvre l'ouverture (OUV) et repose sur la traverse inférieure (T1) de sorte que la traverse inférieure (T1) empêche une translation du boîtier (BO), contre la traverse inférieure (T1), dans un plan perpendiculaire à l'axe longitudinal (y1), sous l'effet de son poids, le boîtier (BO) comprenant un ensemble d'au moins une butée du boîtier (BUB1, BUB2), la butée du boîtier (BUB1, BUB2) venant en appui sur une butée du bâti (BUA1, BUA2) lorsque le boîtier (BO) se trouve dans la position angulaire de maintenance de façon à empêcher la rotation du boîtier (BO) sous l'effet de son poids autour de la traverse inférieure (T1) ;
dans lequel le bâti (BAT) comprend une échancrure (E1, E2) susceptible d'être traversée par la butée (BUB1, BUB2) du boîtier (BO), suite à un soulèvement du boîtier (BO), initialement dans la position angulaire de maintenance par rapport au bâti (BAT).

2. Ensemble électromécanique selon la revendication 1, dans lequel le boîtier (BO) comprend une rainure (RB) destinée à recevoir la traverse inférieure (T1) pour monter le boîtier (BO) sur le bâti (BAT) de façon amovible.

3. Ensemble électromécanique selon la revendication précédente, dans lequel la rainure (RB) est configurée de façon que le boîtier (BO) soit en appui sur la traverse inférieure (T1) lorsque le boîtier (BO) est dans la position angulaire de maintenance de façon que le poids du boîtier (BO) tende à éloigner le boîtier (BO) de la position angulaire de service par rotation du boîtier autour de la traverse inférieure (T1).

4. Ensemble électromécanique selon la revendication précédente, dans lequel la rainure (RB) est délimitée par une première cloison (CL1) du boîtier (BO) reposant sur la traverse inférieure (T1) dans la position angulaire de maintenance de sorte que la traverse inférieure (T1) empêche la translation du boîtier (BO) contre la traverse (T1) selon l'axe perpendiculaire à l'axe longitudinal (y1) sous l'effet de son poids, la rainure étant délimitée par une deuxième cloison (PA) en appui sur la traverse inférieure (T1) lorsque le boîtier (BO) est dans la position angulaire de maintenance de façon que le poids du boîtier (BO) tende à éloigner le boîtier (BO) de la position angulaire de service par rotation du boîtier (BO) autour de la traverse inférieure (T1), la première cloison (CL1) et la deuxième cloison (PA) étant raccordées par un fond (FD) reposant sur la traverse (T1) dans la position angulaire de service.

5. Ensemble électromécanique selon la revendication précédente, dans lequel la première cloison (CL1) et la deuxième cloison (PA) comprenant des faces internes sensiblement parallèles délimitant la rainure (RB) et étant raccordées par le fond (FD).

6. Ensemble électromécanique selon l'une quelconque des revendications précédentes, dans lequel la butée (BUB1, BUB2) du boîtier (BO) présente une forme de plaque.

7. Ensemble électromécanique selon l'une quelconque des revendications précédentes, dans lequel le bâti (BAT) et le boîtier (BO) sont configurés de façon que le boîtier (BO) se trouve uniquement dans un demi-espace, délimité par un plan horizontal passant sensiblement par la traverse inférieure (T1), dans la position angulaire de service et/ou dans la position de maintenance.

8. Ensemble électromécanique selon l'une quelconque des revendications précédentes, dans lequel le boîtier électronique comporte au moins un connecteur électrique.

9. Ensemble électromécanique selon l'une quelconque des revendications précédentes, dans lequel le bâti (BAT) est une partie d'une planche de bord d'aéronef, le boîtier (BO) étant un dispositif de visualisation aéronautique.

## Patentansprüche

1. Elektromechanische Einheit, die ein Gestell (BAT) umfasst, das eine Öffnung (OUV) umfasst, die von einem unteren Querträger (T1) des Gestells (BAT) begrenzt wird, wobei sich der untere Querträger (T1) longitudinal entlang einer Längsachse (y1) erstreckt, **dadurch gekennzeichnet, dass** die elektromechanische Einheit ein Gehäuse (BO) umfasst, das zum abnehmbaren Montieren auf dem Gestell (BAT) bestimmt ist, so dass das Gehäuse (BO) durch Drehung um den unteren Querträger (T1) von einer Betriebswinkelposition, in der das Gehäuse (BO) die Öffnung (OUV) verschließt, in eine Wartungswinkelposition überführt werden kann, in der das Gehäuse (BO) die Öffnung (OUV) öffnet und auf dem unteren Querträger (T1) ruht, so dass der untere Querträger (T1) eine Translation des Gehäuses (BO) gegen den unteren Querträger (T1) in einer Ebene lotrecht zur Längsachse (y1) unter der Wirkung seines Gewichts verhindert, wobei das Gehäuse (BO) eine Anordnung aus mindestens einem Gehäuseanschlag (BUB1, BUB2) umfasst, wobei der Gehäuseanschlag (BUB1, BUB2) an einem Gestellanschlag (BUA1, BUA2) zur Anlage kommt, wenn sich das Gehäuse (BO) in der Wartungswinkelposition befindet, um die Drehung des Gehäuses (BO) unter der Wirkung seines Gewichts um den unteren Querträger (T1) zu verhindern;
wobei das Gestell (BAT) eine Aussparung (E1, E2) umfasst, durch die der Anschlag (BUB1, BUB2) des Gehäuses (BO) nach einem Anheben des Gehäuses (BO), das sich anfangs in der Wartungswinkelposition in Bezug auf das Gehäuse (BAT) befindet, laufen kann.

2. Elektromechanische Einheit nach Anspruch 1, wobei das Gehäuse (BO) eine Nut (RB) zur Aufnahme des unteren Querträgers (T1) aufweist, um das Gehäuse (BO) abnehmbar auf dem Gestell (BAT) zu montieren.

3. Elektromechanische Einheit nach dem vorhergehenden Anspruch, wobei die Nut (RB) so konfiguriert ist, dass das Gehäuse (BO) auf dem unteren Querträger (T1) aufliegt, wenn sich das Gehäuse (BO) in der Wartungswinkelposition befindet, so dass das Gewicht des Gehäuses (BO) dazu neigt, das Gehäuse (BO) durch Drehung des Gehäuses um den unteren Querträger (T1) von der Wartungswinkelposition weg zu bewegen.

4. Elektromechanische Einheit nach dem vorhergehenden Anspruch, wobei die Nut (RB) durch eine erste Trennwand (CL1) des Gehäuses (BO) begrenzt ist, die in der Wartungswinkelposition auf dem unteren Querträger (T1) aufliegt, so dass der untere Querträger (T1) die Translation des Gehäuses (BO) gegen den Querträger (T1) entlang der Achse lotrecht zur Längsachse (y1) unter der Wirkung seines Gewichts verhindert, wobei die Nut durch eine zweite Trennwand (PA) begrenzt wird, die am unteren Querträger (T1) anliegt, wenn sich das Gehäuse (BO) in der Wartungswinkelposition befindet, so dass das Gewicht des Gehäuses (BO) dazu neigt, das Gehäuse (BO) durch Drehung des Gehäuses (BO) um den unteren Querträger (T1) von der Wartungswinkelposition weg zu bewegen, wobei die erste Trennwand (CL1) und die zweite Trennwand (PA) durch einen Boden (FD) verbunden sind, der in der Betriebswinkelposition auf dem Querträger (T1) aufliegt.

5. Elektromechanische Einheit nach dem vorhergehenden Anspruch, wobei die erste Trennwand (CL1) und die zweite Trennwand (PA) im Wesentlichen parallele Innenflächen umfassen, die die Nut (RB) begrenzen und durch den Boden (FD) verbunden sind.

6. Elektromechanische Einheit nach einem der vorhergehenden Ansprüche, wobei der Anschlag (BUB1, BUB2) des Gehäuses (BO) plattenförmig ist.

7. Elektromechanische Einheit nach einem der vorhergehenden Ansprüche, wobei das Gestell (BAT) und das Gehäuse (BO) so konfiguriert sind, dass sich das Gehäuse (BO) in der Betriebswinkelposition und/oder in der Wartungsposition nur in einem Halbraum befindet, der durch eine horizontale Ebene begrenzt ist, die im Wesentlichen durch den unteren Querträger (T1) verläuft.

8. Elektromechanische Einheit nach einem der vorhergehenden Ansprüche, wobei das elektronische Gehäuse mindestens einen elektrischen Anschluss umfasst.

9. Elektromechanische Einheit nach einem der vorherigen Ansprüche, wobei das Gestell (BAT) Teil eines Luftfahrzeuginstrumentenbretts ist, wobei das Gehäuse (BO) eine Luftfahrt-Anzeigevorrichtung ist.

## Claims

1. An electromechanical assembly comprising a frame (BAT) comprising an opening (OUV) delimited by a lower crosspiece (T1) of the frame (BAT), with the lower crosspiece (T1) extending longitudinally along a longitudinal axis (y1), **characterised in that** the electromechanical assembly comprises a housing (BO) intended to be detachably mounted on the frame (BAT) so that the housing (BO) is able to transition, by rotating about the lower crosspiece (T1) from an angular operating position, in which the housing (BO) closes the opening (OUV), to an angular maintenance position, in which the housing (BO) opens the opening (OUV) and rests on the lower crosspiece (T1) so that the lower crosspiece (T1) prevents a translation movement of the housing (BO) against the lower crosspiece (T1) in a plane perpendicular to the longitudinal axis (y1), under the effect of its weight, the housing (BO) comprising a set of at least one stop (BUB1, BUB2) of the housing, the stop (BUB1, BUB2) of the housing coming into abutment on a stop (BUA1, BUA2) of the frame when the housing (BO) is in the angular maintenance position so as to prevent the housing (BO) from rotating about the lower crosspiece (T1) under the effect of its weight,
wherein the frame (BAT) comprises a notch (E1, E2) that can be traversed by the stop (BUB1, BUB2) of the housing (BO) after the housing (BO) is raised, initially in the angular maintenance position relative to the frame (BAT).

2. The electromechanical assembly according to claim 1, wherein the housing (BO) comprises a groove (RB) intended to accommodate the lower crosspiece (T1) for detachably mounting the housing (BO) on the frame (BAT).

3. The electromechanical assembly according to the preceding claim, wherein the groove (RB) is configured such that the housing (BO) is in abutment on the lower crosspiece (T1) when the housing (BO) is in the angular maintenance position such that the weight of the housing (BO) tends to move the housing (BO) away from the angular operating position by rotating the housing about the lower crosspiece (T1).

4. The electromechanical assembly according to the preceding claim, wherein the groove (RB) is delimited by a first partition (CL1) of the housing (BO) resting on the lower crosspiece (T1) in the angular maintenance position such that the lower crosspiece (T1) prevents translation movement of the housing (BO) against the crosspiece (T1) along the axis perpendicular to the longitudinal axis (y1) under the effect of its weight, the groove being delimited by a second partition (PA) in abutment on the lower crosspiece (T1) when the housing (BO) is in the angular maintenance position such that the weight of the housing (BO) tends to move the housing (BO) away from the angular operating position by rotating the housing (BO) about the lower crosspiece (T1), the first partition (CL1) and the second partition (PA) being connected by a base (FD) resting on the crosspiece (T1) in the angular operating position.

5. The electromechanical assembly according to the preceding claim, wherein the first partition (CL1) and the second partition (PA) comprise substantially parallel inner faces delimiting the groove (RB) and being connected by the base (FD).

6. The electromechanical assembly according to any one of the preceding claims, wherein the stop (BUB1, BUB2) of the housing (BO) is in the shape of a plate.

7. The electromechanical assembly according to any one of the preceding claims, wherein the frame (BAT) and the housing (BO) are configured such that the housing (BO) is only located in a half-space, delimited by a horizontal plane substantially passing through the lower crosspiece (T1), in the angular operating position and/or in the maintenance position.

8. The electromechanical assembly according to any one of the preceding claims, wherein the electronic housing comprises at least one electrical connector.

9. The electromechanical assembly according to any one of the preceding claims, wherein the frame (BAT) is a part of an aircraft instrument panel, the housing (BO) being an aeronautical visualisation device.
